# EUROPEAN PATENT SPECIFICATION

(11) **EP 4 344 360 B1**
(45) Date of publication and mention of the grant of the patent: **25.03.2026**
(21) Application number: 21947630.6
(22) Date of filing: 01.07.2021
(51) Int. Cl.: H05K 1/02, H05K 3/46, H05K 1/18

(54) **PRINTED CIRCUIT BOARD AND ELECTRONIC DEVICE**
LEITERPLATTE UND ELEKTRONISCHE VORRICHTUNG
CARTE DE CIRCUIT IMPRIMÉ ET DISPOSITIF ÉLECTRONIQUE

(43) Date of publication of application: 27.03.2024
(73) Proprietor: Huawei Technologies Co., Ltd., Shenzhen, Guangdong 518129 (CN)
(72) Inventor: TAO, Wei, Shenzhen, Guangdong 518129 (CN); JIN, Yupeng, Shenzhen, Guangdong 518129 (CN); SANG, Yalei, Shenzhen, Guangdong 518129 (CN); CHEN, Zhenyu, Shenzhen, Guangdong 518129 (CN); ZAIMURAN, Wusiman, Shenzhen, Guangdong 518129 (CN)
(74) Representative: Epping - Hermann - Fischer
(86) International application number: PCT/CN2021/103976
(87) International publication number: WO 2023/272677

(56) References cited:
- CN-A- 101 038 881
- CN-A- 104 602 448
- CN-U- 207 491 300
- JP-A- 2016 032 080
- TW-U- M 320 824
- US-A1- 2007 120 249
- US-A1- 2009 151 989

## Description

### TECHNICAL FIELD

This application relates to the field of printed circuit boards, and in particular, to a printed circuit board and an electronic device.

### BACKGROUND

As energy products evolve toward high power and high density, a quantity of layers and a copper thickness of a printed circuit board (printed circuit board, PCB) of an energy product increase, causing an increase in a coefficient of thermal expansion (coefficient of thermal expansion, CTE) and a Young's modulus of the printed circuit board. Consequently, the challenge of reliability of solder joints of high-power devices is increasing. A conventional PCB board material cannot meet a test requirement of long-term reliability of solder joints, and a solder joint crack problem is prone to occur.

US 2007/120249 Al discloses a circuit substrate including a plurality of dielectric members and a plurality of wiring patterns. The plurality of wiring patterns are stacked on one another through the plurality of dielectric members. The plurality of dielectric members includes a mount dielectric member. A first wiring pattern of the plurality of wiring patterns is provided on a side of the mount dielectric member. A second wiring pattern of the plurality of wiring patterns is provided on an opposite side of the mount dielectric member. A first length is a length between a reinforcing medium of the mount dielectric member and the opposite side of the mount dielectric member in a thickness direction. A second length is a length between the reinforcing medium of the mount dielectric member and the side of the mount dielectric member in the thickness direction. The first length is smaller than the second length. The mount dielectric member A includes a resin part (resin substrate) and a reinforcing part (reinforcing substrate). The resin part has the linear expansion coefficient of x=y=50 ppm, and Young's modulus of 2100 MPa.

US 2009/151989 Al discloses a device for mounting electrical components, the device comprising: a printed circuit board comprising: a surface conductive layer configured to interface with the electrical components, wherein the surface conductive layer comprises rolled-annealed copper; a strain resistant cap layer configured to engage the surface conductive layer, wherein the strain resistant cap layer comprises polyimide; and one or more rigid insulating layers, wherein at least one of the one or more rigid insulating layers extends throughout the entire length of the printed circuit board such that the entire printed circuit board defines a rigid printed circuit board.

JP 2016 032080 A discloses a circuit board including: a layered part in which a conductor layer and an insulation layer are layered; and a fixing part partially inserted in the layered part. The fixing part includes a first depressing part and a second depressing part which sandwich the layered part in a thickness direction. The circuit board includes: a first hole part composed to pierce the layered part in the thickness direction; and a reinforcement part arranged at a position closer to the first hole part. The reinforcement part includes: a second hole part composed to extend in the thickness direction of the layered part at a position of the layered part and closer to the first hole part; and a reinforcement material which is composed of a material having an elastic modulus higher than that of the flexible layer and arranged with a composition extending in the second hole part in the thickness direction.

CN 104 602 448 A discloses a manufacturing method of a flexible circuit board comprising the following steps: providing a core circuit board, wherein the core circuit board comprises a first insulating base material and conductive line patterns formed on the two sides of the first insulating base material, the first insulating base material has a discontinuous glass fiber cloth layer and an insulating colloid, the insulating colloid is integrally connected with the glass fiber cloth layer, and a bending area is formed in an area, which is provided with the insulating colloid and does not contain the glass fiber cloth layer, of the core circuit board; providing a first substrate and a first adhesive sheet, and sequentially stacking and press-fitting the first substrate, the first adhesive sheet and the core circuit board to obtain a multilayer substrate; and removing the first substrate and a partial area, corresponding to the bending area, of the first adhesive sheet, so as to form a flexible circuit board.

CN 207 491 300 U is related to a kind of epoxy acrylic resin mixed circuit board, including core plate, upper conductor layer, lower conductor layer, upper insulating medium layer, lower insulating medium layer, upper heat dissipating layer and lower heat dissipating layer. Core plate includes upper substrate, lower substrate, the prepreg for being located in upper and lower base plate and through the upper and lower base plate and the rivet of prepreg. Between upper conductor layer and core plate, it is stacked with heat dissipating layer and upper insulating medium layer respectively from the bottom to top, upper insulating medium layer is alternately combined by one layer of upper ptfe porous membrane and one layer of upper bonding sheet, the upper bonding sheet uses epoxy acrylic resin bonding sheet, and radiating flow passage is equipped in the upper heat dissipating layer. Between lower conductor layer and core plate, it is from top to bottom stacked with lower heat dissipating layer and lower insulating medium layer respectively, lower insulating medium layer is alternately combined by one layer of lower ptfe porous membrane and one layer of lower bonding sheet, lower bonding sheet uses epoxy acrylic resin bonding sheet, and radiating flow passage is equipped in lower heat dissipating layer.

CN 101 0388 81 A discloses a manufacturing method of a substrate, which comprises the following steps: providing a first conductive film with a plurality of conductive bumps, and fixing a component on the first conductive film, wherein the component is provided with a plurality of electrodes, and the conductive bumps are electrically connected with the electrodes; in addition, a core board with an accommodating space is provided, and the upper side and the lower side of the core board are provided with inner layer circuits; then, embedding the element into the accommodating space, forming an insulating part to coat the element, the core board and the inner layer circuits on the upper side and the lower side of the core board, wherein the first conductive film is positioned below the element, and the second conductive film is formed on the insulating part above the element; then forming a plurality of through holes to penetrate through the second conductive film, the insulating part, the core plate and the first conductive film; then, forming a conductive layer on the side wall of the through hole, and patterning the first conductive film and the second conductive film to form an outer layer circuit; finally, a solder mask layer is formed on the outer layer circuit. TW M 320 824 U discloses a buried passive component molding device, which comprises at least: a core board having an inner layer circuit layer on the lower side; at least two conductive layers disposed on the lower side of the core board. The buried layer is disposed between the conductive layer and the inner layer of the core board. The polymer layer is disposed on the other side of each conductive layer relative to the core board; the pressing member is disposed outside the polymer layer. The polymer layer is pressed and combined to form a core board, an embedded layer and a conductive laminate to form a buried passive component.

### SUMMARY

Embodiments of this application provide a printed circuit board and an electronic device, to reduce a Young's modulus of a printed circuit board and improve reliability of a solder joint between a power device and the PCB.

According to a first aspect, the present invention provides a printed circuit board as defined in claim 1, including a core board and a substrate. The core board covers and is disposed on one of two opposing outer surfaces of the substrate. The core board includes a first conductive layer, a second conductive layer, and a first dielectric layer. The first conductive layer is located on a side that is of the core board and that is away from the substrate, the second conductive layer is located on a side that is of the core board and that is close to the substrate, and the first dielectric layer is located between the first conductive layer and the second conductive layer, and includes a flexible dielectric layer whose Young's modulus is less than or equal to a preset Young's modulus.

In the printed circuit board provided by the present invention, the flexible dielectric layer is hybridly laminated at a dielectric layer between an outermost conductive layer and a secondary outer conductive layer, to reduce a Young's modulus of the dielectric layer between the outermost conductive layer and the secondary outer conductive layer. A modulus of the PCB at the bottom of a solder joint of a power device is reduced, thereby improving reliability of the solder joint between the power device and the PCB and meeting a service life requirement of a product. In addition, a voltage withstanding capability between the outermost conductive layer and the secondary outer conductive layer is enhanced.

The preset Young's modulus is less than or equal to 15 GPa.

In another possible implementation, the core board also covers and is disposed on the other outer surface of the two opposing outer surfaces of the substrate.

According to the present invention, the first dielectric layer further includes prepreg (prepreg, PP) layers that cover and are disposed on an upper surface and a lower surface of the flexible dielectric layer, and the first dielectric layer is formed through hybrid lamination on the flexible dielectric layer and the prepreg layers.

The prepeg layers include a prepeg that partially or completely covers the upper surface of the flexible dielectric layer and the prepeg layers include a prepeg that partially or completely covers the lower surface of the flexible dielectric layer . The flexible dielectric layer is closely connected to both the first conductive layer and the second conductive layer by using the prepreg layers.

Optionally, the prepreg of the pepeg layers is an FR4 prepreg.

In another possible implementation, a pad is disposed at the first conductive layer, and the flexible dielectric layer is disposed at a position that corresponds to the pad and is at the first dielectric layer.

In a possible implementation, the substrate includes N third conductive layers and M second dielectric layers, and the third conductive layers and the second dielectric layers are alternately stacked, where N = M + 1, both N and M are natural numbers, and a Young's modulus of the first dielectric layer is less than a Young's modulus of the second dielectric layer. In another possible implementation, the substrate includes N third conductive layers and M second dielectric layers, and the third conductive layers and the second dielectric layers are alternately stacked, where M = N + 1, both N and M are natural numbers, and a part of the M second dielectric layers includes the flexible dielectric layer, or each of the M second dielectric layers includes the flexible dielectric layer.

In another possible implementation, a coefficient of thermal expansion of the flexible dielectric layer in an X-axis direction and a Y-axis direction is less than or equal to a preset threshold.

The preset threshold is less than or equal to 30.

In the printed circuit board provided in this embodiment of this application, the flexible dielectric layer whose Young's modulus is less than the preset Young's modulus and whose CTE in the X-axis direction and the Y-axis direction is less than the preset threshold is hybridly laminated at the dielectric layer between the outermost conductive layer and the secondary outer conductive layer, so that both the Young's modulus and the CTE of the PCB are reduced, and reliability of the solder joint between the power device and the PCB is further improved.

Optionally, the flexible dielectric layer is made of a polyimide material.

According to a second aspect, an embodiment of the present invention further provides an electronic device, including a power device and the printed circuit board provided in the first aspect. The power device is electrically connected to the printed circuit board, and a service life of the electronic device is prolonged.

### BRIEF DESCRIPTION OF DRAWINGS

FIG. 1 is a schematic diagram of a structure of a printed circuit board according to an embodiment of this application;
FIG. 2 is a flowchart of manufacturing the printed circuit board shown in FIG. 1 according to an embodiment of this application;
FIG. 3 is a schematic diagram of a structure of another printed circuit board according to an embodiment of this application;
FIG. 4 is a flowchart of manufacturing the printed circuit board shown in FIG. 3 according to an embodiment of this application;
FIG. 5 is a schematic diagram of a structure of another printed circuit board according to an embodiment of this application; and
FIG. 6 is a flowchart of manufacturing the printed circuit board shown in FIG. 5 according to an embodiment of this application.

### DESCRIPTION OF EMBODIMENTS

The following describes technical solutions in embodiments of this application with reference to accompanying drawings in embodiments of this application.

In descriptions of this application, locations or location relationships indicated by terms "center", "up", "down", "in front of", "behind", "left", "right", "vertical", "horizontal", "top", "bottom", "inside", "outside", and the like are based on locations or location relationships shown in the accompanying drawings, and are merely intended for ease of describing this application and simplifying descriptions, instead of indicating or implying that a mentioned apparatus or component needs to be provided on a specific location or constructed and operated on a specific location, and therefore shall not be understood as limitations on this application.

In the descriptions of this application, it should be noted that, unless otherwise clearly specified and limited, terms "mount", "link", and "connect" should be understood in a broad sense, for example, may mean a fixed connection, may be a detachable connection, or may be a butt joint connection or an integrated connection. A person of ordinary skill in the art can understand specific meanings of the foregoing terms in this application based on specific cases.

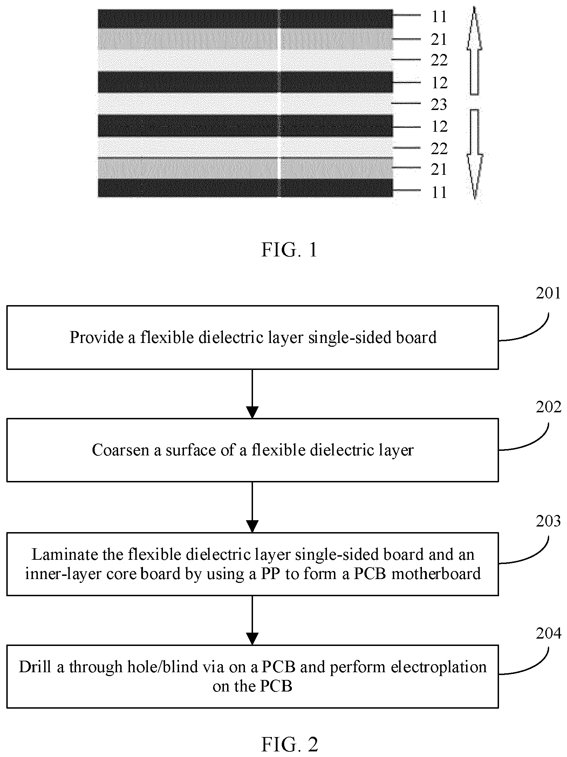

This application provides a printed circuit board. The printed circuit board is of a laminated structure, including a plurality of conductive layers and dielectric layers that are alternately stacked. As shown in FIG. 1, the conductive layers may include four layers (for example, two first conductive layers 11 and two second conductive layers 12 in FIG. 1), and the dielectric layers may include three layers (for example, two first dielectric layers (including a flexible dielectric layer 21 and a PP layer 22) in FIG. 1 and a central dielectric layer 23 (core) located at the central layer of the laminated structure). Certainly, FIG. 1 shows only a possible structure of the printed circuit board. A quantity of conductive layers and a quantity of dielectric layers may be set based on an actual requirement. The quantity of conductive layers and the quantity of dielectric layers are not limited in this application.

The conductive layers and the dielectric layers are alternately stacked, and the conductive layer is disposed on an upper surface of the dielectric layer.

Generally, an outer surface of a PCB is a side surface that is of the PCB and that is used to dispose a pad or solder a power device. The upper surface of the dielectric layer is a side surface that is of the dielectric layer and that is close to the outer surface of the PCB, and a lower surface of the dielectric layer is a side surface that is of the dielectric layer and that is away from the outer surface of the PCB.

The conductive layer is made of a conductive material. The conductive material is usually a conductor with relatively good conductive performance, such as copper, aluminum, or silver. The conductive layer may be connected to a ground cable to shield and protect a signal.

The dielectric layer is made of an insulation material, and therefore is usually also referred to as an insulation layer. The dielectric layer mainly plays a role of supporting the conductive layer.

Still refer to FIG. 1. The first conductive layer 11 and the second conductive layer 12 are respectively an outermost conductive layer and a secondary outer conductive layer of the plurality of conductive layers of the laminated structure. In other words, the first conductive layer 11 and the second conductive layer 12 are respectively the outermost conductive layer and the secondary outer conductive layer of the plurality of conductive layers in a direction (that is, an arrow direction in FIG. 1) away from the core layer 23.

The first dielectric layer is located between the first conductive layer 11 and the second conductive layer 12.

It is easy to understand that the direction away from the core layer 23 has two opposing directions (referring to arrow directions in the figure) with the core layer 23 as a start point. Therefore, there are two first conductive layers 11 and two second conductive layers 12, and there are also two first dielectric layers.

The first dielectric layer includes the flexible dielectric layer 21 whose Young's modulus is less than or equal to a preset Young's modulus.

According to the invention, the preset Young's modulus is less than or equal to 15 GPa. In other words, the Young's modulus of the flexible dielectric layer is less than or equal to 15 GPa.

In the printed circuit board provided in this embodiment of this application, the flexible dielectric layer is hybridly laminated at the dielectric layer between the outermost conductive layer and the secondary outer conductive layer, to reduce a Young's modulus of the dielectric layer between the outermost conductive layer and the secondary outer conductive layer. A modulus of the PCB at the bottom of a solder joint of the power device is reduced, thereby improving reliability of the solder joint between the power device and the PCB and meeting a service life requirement of a product. In addition, a voltage withstanding capability between the outermost conductive layer and the secondary outer conductive layer is enhanced.

In an example, the first dielectric layer is formed through hybrid lamination on the PP layer and the flexible dielectric layer. Because the Young's modulus of the flexible dielectric layer is less than a Young's modulus of the PP layer, a Young's modulus of the first dielectric layer obtained through hybrid lamination on the PP layer and the flexible dielectric layer is also less than the Young's modulus of the PP layer, so that the Young's modulus of the first dielectric layer is effectively reduced.

For example, in FIG. 1, the PP layer 22 includes a PP that partially or completely covers a surface that is of the flexible dielectric layer 21 and that is close to the second conductive layer 12. A surface that is of the flexible dielectric layer 21 and that is close to the first conductive layer is closely attached to the first conductive layer 11, and the PP is closely attached to both the flexible dielectric layer 21 and the second conductive layer 12, to firmly bond the flexible dielectric layer 21 and the second conductive layer 12.

The PP is an interlayer adhesive. With the help of a high temperature and high pressure environment of a lamination machine, the PP is first softened and then hardened, and changes from a B-stage to a C-stage to make two layers bonded by using the PP as an integrated one. For example, in FIG. 1, the PP bonds the flexible dielectric layer 21 and the second conductive layer 12 as an integrated one.

The PP may be made of a thermally cured or thermoplastic material, for example, a phenolic aldehyde resin, a ureaformaldehyde resin, a melamine resin, an unsaturated polyester resin, an epoxy resin, an organic silicone resin, or polyurethane. This is not limited in this application. A proper material may be selected to prepare the PP based on a requirement.

FIG. 2 is a flowchart of manufacturing the printed circuit board shown in FIG. 1 according to an embodiment of this application. As shown in FIG. 2, a process of manufacturing the printed circuit board shown in FIG. 1 includes step S201 to step S204.

Step S201: Provide a flexible dielectric layer single-sided board, where the flexible dielectric layer single-sided board includes a flexible dielectric layer and a conductive layer formed on a surface of the flexible dielectric layer, for example, a copper foil layer.

Step S202: Coarsen a surface of the flexible dielectric layer, so that the flexible dielectric layer single-sided board is more easily bonded and fixed to an inner-layer core board.

Step S203: Laminate the flexible dielectric layer single-sided board and the inner-layer core board by using the PP to form a PCB motherboard.

For example, the flexible dielectric layer single-sided board (a side that is of the flexible dielectric layer single-sided board and that is away from the conductive layer is disposed towards the PP), the PP, the inner-layer core board, the PP, and the flexible dielectric layer single-sided board are sequentially stacked and laminated to form the PCB motherboard.

In this step, a laminated structure formed by stacking the flexible dielectric layer single-sided board, the PP, the inner-layer core board, the PP, and the flexible dielectric layer single-sided board may be coated with an adhesive-resistant release film, and then a lamination operation is performed, to avoid a phenomenon of a PP outflow because the PP is melted into glue during a lamination process.

It is easy to understand that the inner-layer core board is a core board located at an inner layer of the PCB, for example, the core layer 23 and the second conductive layers 12 respectively covering the upper and lower surfaces of the core layer 23 in FIG. 1.

Step S204: Drill a through hole/blind via on the PCB and perform electroplation on the PCB to implement conduction between the conductive layers.

A via is drilled on at least one dielectric layer and one conductive layer along a stacking direction of the dielectric layer and the conductive layer. When no via is drilled at a dielectric layer and a conductive layer, a blind via is formed on the PCB. When a via is drilled at each dielectric layer and each conductive layer, a through hole through the PCB is formed on the PCB.

The blind via is generally used to connect a surface trace and an inner trace below. Generally, a ratio of a depth of the via to a diameter of the via does not exceed a specific ratio.

The through hole is generally used for internal interconnection or used as a positioning hole for mounting a component and a device.

The via is configured to conduct traces located at different layers, the via is filled with a material medium to form a via core, and the via core is insulated from the conductive layer and is electrically connected to a trace that needs to be conducted.

The via may be separately disposed, and the via core in the via is electrically connected to another structure, for example, a pad disposed at the conductive layer, by using a trace. In addition, a pad may be directly disposed on the via, and then the power device is soldered on the pad, so that the power device can also be electrically connected to the via core in the via. The power device may be, for example, an electrical component such as a MOS transistor or a chip.

During implementation, the via core and the conductive layer may be disposed at an interval to implement insulation between the via core and the conductive layer. Alternatively, the insulation material may be disposed between the via core and the conductive layer, for example, an insulating resin is coated or insulating rubber is disposed, to implement insulation between the via core and the conductive layer.

A hole forming process such as plasma hole forming, photosensitive hole forming, and laser hole forming may be selected as a hole drilling process of the through hole or the blind via. This is not limited in this embodiment of this application. A proper hole forming process may be selected based on an actual situation.

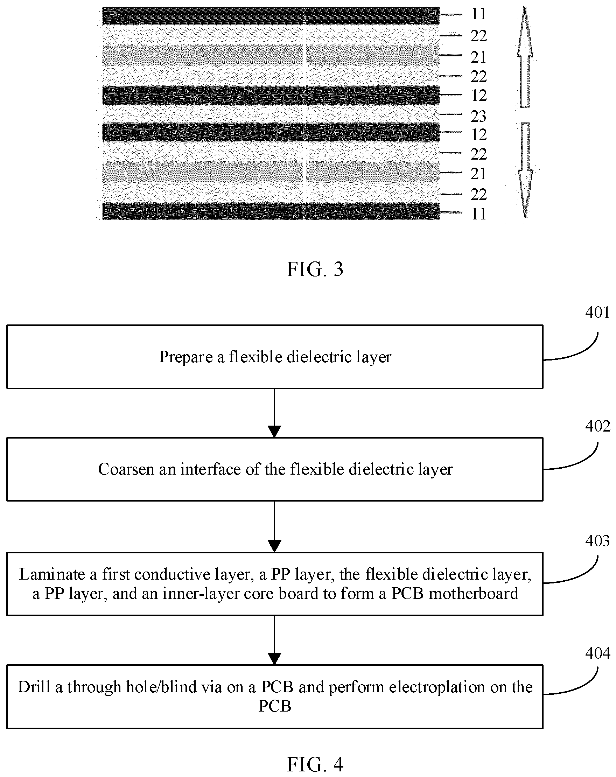

FIG. 3 is a schematic diagram of a structure of another printed circuit board according to an embodiment of this application. As shown in FIG. 3, a difference from the printed circuit board shown in FIG. 1 lies in that, a first dielectric layer includes PP layers 22 that cover and are disposed on an upper surface and a lower surface of a flexible dielectric layer 21. The PP layer 22 includes a PP that partially or completely covers the upper surface or the lower surface of the flexible dielectric layer 21, and the flexible dielectric layer 21 is closely connected to a first conductive layer and a second conductive layer by using the PP.

It should be explained that the upper surface of the flexible dielectric layer 21 is a surface of a side that is of the flexible dielectric layer and that is close to the first conductive layer 11, and the lower surface of the flexible dielectric layer is a surface of a side that is of the flexible dielectric layer and that is close to the second conductive layer 12. In other words, the upper surface of the flexible dielectric layer is a surface of a side that is of the flexible dielectric layer and that is away from a core layer 23, and the lower surface of the flexible dielectric layer is a surface of a side that is of the flexible dielectric layer and that is close to the core layer 23.

In an example, the PP mentioned above is an FR4 PP.

FIG. 4 is a flowchart of manufacturing the printed circuit board shown in FIG. 3 according to an embodiment of this application. As shown in FIG. 4, a process of manufacturing the printed circuit board shown in FIG. 3 includes step S401 to step S404.

Step S401: Prepare the flexible dielectric layer.

That is, a flexible dielectric material is made into a plate-like structure. For example, the flexible dielectric material is laminated into a plate-like flexible dielectric layer.

Step S402: Coarsen a surface of the flexible dielectric layer.

Both the upper and lower surfaces of the flexible dielectric layer are coarsened, so that the flexible dielectric layer is more easily bonded and fixed to the PP.

Step S403: Laminate the first conductive layer, a PP layer, the flexible dielectric layer, a PP layer, and an inner-layer core board to form a PCB motherboard.

For example, the first conductive layer, the PP layer, the flexible dielectric layer, the PP layer, the inner-layer core board, the PP layer, the flexible dielectric layer, the PP layer, and the first conductive layer are sequentially stacked and laminated to form the PCB motherboard.

A sandwich structure of the PP layer, the flexible dielectric layer, and the PP layer are formed at the first dielectric layer.

It is easy to understand that the inner-layer core board is a core board located at an inner layer of the PCB, for example, the core layer 23 and the second conductive layers 12 respectively covering the upper and lower surfaces of the core layer 23 in FIG. 3.

Step S404: Drill a through hole/blind via on the PCB and perform electroplation on the PCB to implement conduction between the conductive layers.

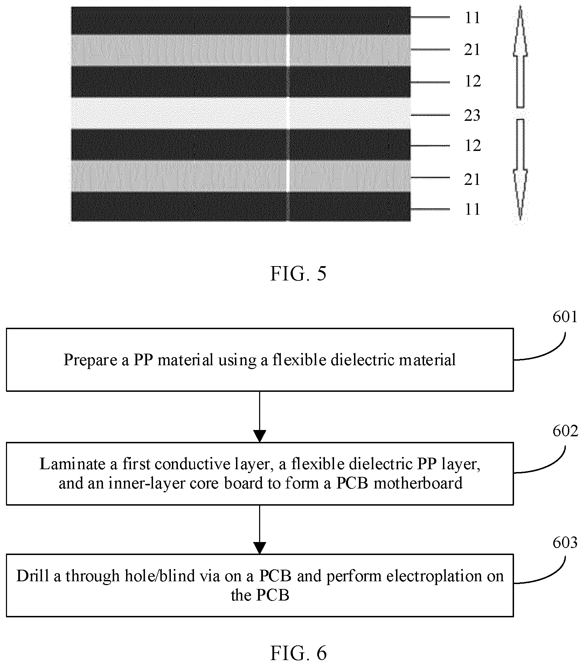

FIG. 5 is a schematic diagram of a structure of another printed circuit board according to an embodiment of this application. As shown in FIG. 5, a difference from the printed circuit boards shown in FIG. 1 and FIG. 3 lies in that a first dielectric layer includes only a flexible dielectric layer, and an upper surface and a lower surface of the flexible dielectric layer are respectively closely attached to a first conductive layer and a second conductive layer.

It should be explained that the upper surface of the flexible dielectric layer 21 is a surface of a side that is of the flexible dielectric layer 21 and that is close to the first conductive layer 11, and the lower surface of the flexible dielectric layer 21 is a surface of a side that is of the flexible dielectric layer 21 and that is close to the second conductive layer 12. In other words, the upper surface of the flexible dielectric layer 21 is a surface of a side that is of the flexible dielectric layer 21 and that is away from a core layer 23, and the lower surface of the flexible dielectric layer 21 is a surface of a side that is of the flexible dielectric layer 21 and that is close to the core layer 23.

FIG. 6 is a flowchart of manufacturing the printed circuit board shown in FIG. 5 according to an embodiment of this application. As shown in FIG. 6, a process of manufacturing the printed circuit board shown in FIG. 5 includes step S601 to step S603.

Step S601: Prepare a PP material using a flexible dielectric material.

That is, a dielectric material whose Young's modulus is less than 15 GPa is selected to prepare the PP material. For example, a polyimide (polyimide, PI) material is selected to prepare the PP material.

Step S602: Laminate the first conductive layer, a flexible dielectric PP layer, and an inner-layer core board to form a PCB motherboard.

For example, the first conductive layer, the flexible dielectric PP layer, the inner-layer core board, the flexible dielectric PP layer, and the first conductive layer are sequentially stacked and laminated to form the PCB motherboard.

It is easy to understand that the inner-layer core board is a core board located at an inner layer of the PCB, for example, the core layer 23 and the second conductive layers 12 respectively covering the upper and lower surfaces of the core layer 23 in FIG. 5.

Step S603: Drill a through hole/blind via on the PCB and perform electroplation on the PCB to implement conduction between the conductive layers.

It may be understood that the manufacturing processes provided in FIG. 2, FIG. 4, and FIG. 6 for the printed circuit boards in FIG. 1, FIG. 3, and FIG. 5 in embodiments of this application are partial manufacturing processes. For example, after step S204, step S404, or step S603, subsequent manufacturing steps such as outer layer imaging, outer layer etching, outer layer inspection, solder mask/silkscreen, surface processing, milling, electrical performance test, final quality control, and packaging are further included.

In an example, the flexible dielectric layer may be hybridly laminated to the entire layer of the first dielectric layer. For example, the flexible dielectric layer is hybridly laminated to the entire layer of the first dielectric layer of the printed circuit board shown in FIG. 1, FIG. 3, or FIG. 5. In this way, reliability of the solder joint between the power device and the PCB is improved by reducing the Young's modulus of the first dielectric layer, and manufacturing and processing of the first dielectric layer are convenient.

In another example, the flexible dielectric layer may be hybridly laminated to a portion of the first dielectric layer. For example, a pad (not shown in the figure) is disposed at the first conductive layer of the printed circuit board shown in FIG. 1, FIG. 3, or FIG. 5, and the flexible dielectric layer is disposed at a position that corresponds to the pad and is at the first dielectric layer.

It should be explained that, the position that corresponds to the pad and is at the first dielectric layer is an area that is at the first dielectric layer and that affects a solder joint when the power device is soldered on the pad. For example, the position that corresponds to the pad and is at the first dielectric layer is an area that is at the first dielectric layer and that is below the pad, an area of orthographic projection of the pad at the first dielectric layer, an area that is slightly larger than orthographic projection of the pad at the first dielectric layer, or an area that is slightly smaller than orthographic projection of the pad at the first dielectric layer. In this way, reliability of the solder joint between the power device and the PCB is improved by reducing the Young's modulus of the first dielectric layer, and the flexible dielectric material is saved.

The pad includes a functional pad and a non-functional/redundant pad, and is configured to implement an electrical connection and a mechanical connection between the power device (such as a MOS transistor and a chip) and the PCB, to correctly package the power device on the PCB.

It is easy to understand that the core board includes the first conductive layer 11, the dielectric layer including the flexible dielectric layer 21 and the PP layer 22, and the second conductive layer in FIG. 1, FIG. 3, or FIG. 5, and the core layer 23 is the substrate. The core boards cover and are disposed on two opposing outer surfaces of the substrate in extension directions, to reduce Young's moduli of outer layers on both sides of the PCB and improve reliability of the solder joint between the power device and the PCB.

In another example, to simplify the manufacturing process of the printed circuit board, the core board may be disposed only on one side of the substrate, that is, the core board covers only one outer surface of the substrate in an extension direction, and a conventional core board is still used on the other outer surface. For example, the flexible dielectric layer is disposed at the dielectric layer between the first conductive layer 11 and the second conductive layer only in one arrow direction in FIG. 1, FIG. 3, or FIG. 5.

In an example, the substrate includes N third conductive layers and M second dielectric layers, and the third conductive layers and the second dielectric layers are alternately stacked, where M = N + 1, and both N and M are natural numbers. For example, the substrate may be of a single-layer structure, that is, N = 0 and M = 1. For example, the substrate in FIG. 1, FIG. 3, and FIG. 5 only has one dielectric layer, that is, the core layer 23. Alternatively, the substrate may be of a multi-layer structure. For example, N = 1 and M = 2. That is, the substrate has one conductive layer and two dielectric layers, and the dielectric layers and the conductive layer are alternately stacked to form the multi-layer structure. A structure of the substrate may be selected based on a requirement. A specific structure of the substrate is not limited in this application.

To save the flexible dielectric material, the dielectric layer (that is, the second dielectric layer) in the substrate is made of a conventional material, for example, an epoxy resin. A Young's modulus of the second dielectric layer is greater than 20 GPa. Therefore, the Young's modulus of the first dielectric layer is less than the Young's modulus of the second dielectric layer.

In another example, the flexible dielectric layer is disposed at all or some dielectric layers of the substrate. The Young's modulus of the PCB is reduced as a whole, and voltage withstanding of the PCB is improved. In addition, board materials of a plurality of core boards in the PCB are the same, ensuring that moduli and CTEs of the plurality of core boards are the same or approximately the same.

Preferably, a thickness of the flexible dielectric layer is 2-8 mil, a thickness of the PP layer is 2-5 mil, and a thickness of the conductive layer is 3-5 oz.

In an example, a CTE of the flexible dielectric layer in X-axis and Y-axis directions is less than or equal to a preset threshold. For example, the preset threshold is less than or equal to 30. In other words, the CTE of the flexible dielectric layer in the X-axis and Y-axis directions is less than or equal to 30.

It is easy to understand that the X-axis and Y-axis directions of the flexible dielectric layer are surface extension directions of the flexible dielectric layer, that is, directions perpendicular to a thickness direction of the flexible dielectric layer.

In this way, the Young's modulus of the flexible dielectric layer needs to be less than or equal to 15 GPa, and the CTE of the flexible dielectric layer in the X-axis and Y-axis directions needs to be less than or equal to 30.

Optionally, the flexible dielectric layer is made of the polyimide (polyimide, PI) material.

In another example, the inner-layer core boards in FIG. 1, FIG. 3, and FIG. 5 may alternatively be of a multi-layer board structure.

An embodiment of this application provides an electronic device, including a power device and the printed circuit board in the foregoing embodiments, and the power device is electrically connected to the printed circuit board.

For example, a pad is disposed at an outermost layer of the printed circuit board, and the power device (for example, a MOS transistor and a chip) is soldered to the pad to electrically connect to a preset trace in the printed circuit board. Alternatively, a plug hole is disposed on an outer layer of the printed circuit board, and the power device is plugged into the plug hole to electrically connect to the preset trace in the printed circuit board.

The electronic device includes but is not limited to an electronic device, such as a mobile phone, a tablet computer, a wearable device, a notebook computer, an ultra-mobile personal computer (ultra-mobile personal computer, UMPC), a handheld computer, a walkie-talkie, a netbook, a POS machine, a personal digital assistant (personal digital assistant, PDA), an event data recorder, or a virtual reality device.

The foregoing descriptions are merely specific implementations of this application.

## Claims

1. A printed circuit board, comprising: a core board and a substrate, wherein the core board covers and is disposed on one of two opposing outer surfaces of the substrate; and the core board comprises:
a first conductive layer (11), located on a side that is of the core board and that is away from the substrate;
a second conductive layer (12), located on a side that is of the core board and that is close to the substrate; and
a first dielectric layer, located between the first conductive layer (11) and the second conductive layer (12) and comprising a flexible dielectric layer (21), wherein a Young's modulus of the flexible dielectric layer (21) is less than or equal to 15 GPa,
the printed circuit board **characterised in that**
the first dielectric layer further comprises prepreg layers (22) that cover and are disposed on an upper surface and a lower surface of the flexible dielectric layer (21), and the first dielectric layer is formed through hybrid lamination on the flexible dielectric layer (21) and the prepreg layers (22), wherein the prepeg layers (22) include a prepeg that partially or completely covers the upper surface of the flexible dielectric layer (21) and the prepeg layers (22) include a prepeg that partially or completely covers the lower surface of the flexible dielectric layer (21) , and the flexible dielectric layer (21) is closely connected to both the first conductive layer (11) and the second conductive layer (12) by using the prepreg layers (22).

2. The printed circuit board according to claim 1, wherein the core board also covers and is disposed on the other outer surface of the two opposing outer surfaces of the substrate.

3. The printed circuit board according to any one of claims 1 to 2, wherein the prepreg of the prepreg layers (22) is an FR4 prepreg.

4. The printed circuit board according to any one of claims 1 to 3, wherein a pad is disposed at the first conductive layer (11), and the flexible dielectric layer (21) is disposed at a position that corresponds to the pad and is at the first dielectric layer.

5. The printed circuit board according to any one of claims 1 to 4, wherein the substrate comprises N third conductive layers and M second dielectric layers, the third conductive layers and the second dielectric layers are alternately stacked, M = N + 1, and both N and M are natural numbers; and
a Young's modulus of the first dielectric layer is less than a Young's modulus of the second dielectric layer.

6. The printed circuit board according to any one of claims 1 to 5, wherein the substrate comprises N third conductive layers and M second dielectric layers, the third conductive layers and the second dielectric layers are alternately stacked, M = N + 1, and both N and M are natural numbers; and
a part of the M second dielectric layers comprises the flexible dielectric layer (21); or
each of the M second dielectric layers comprises the flexible dielectric layer (21).

7. The printed circuit board according to any one of claims 1 to 6, wherein a coefficient of thermal expansion of the flexible dielectric layer (21) in an X-axis direction and a Y-axis direction is less than or equal to 30.

8. The printed circuit board according to any one of claims 1 to 7, wherein the flexible dielectric layer (21) is made of a polyimide material.

9. An electronic device, comprising a power device and the printed circuit board according to any one of claims 1 to 8, wherein the power device is electrically connected to the printed circuit board.

## Patentansprüche

1. Leiterplatte, umfassend: eine Kernplatte und ein Substrat, wobei die Kernplatte eine von zwei gegenüberliegenden Außenflächen des Substrats bedeckt und auf dieser angeordnet ist; und die Kernplatte Folgendes umfasst:
eine erste leitfähige Schicht (11), die sich auf einer Seite befindet, die von der Kernplatte stammt und die von dem Substrat entfernt ist;
eine zweite leitfähige Schicht (12), die sich auf einer Seite befindet, die von der Kernplatte stammt und die nahe an dem Substrat liegt; und
eine erste dielektrische Schicht, die sich zwischen der ersten leitfähigen Schicht (11) und der zweiten leitfähigen Schicht (12) befindet und eine flexible dielektrische Schicht (21) umfasst, wobei der Young'sche Modul der flexiblen dielektrischen Schicht (21) kleiner oder gleich 15 GPa ist,
wobei die Leiterplatte **dadurch gekennzeichnet ist, dass**
die erste dielektrische Schicht ferner Prepreg-Schichten (22) umfasst, welche eine Oberseite und eine Unterseite der flexiblen dielektrischen Schicht (21) bedecken und auf diesen angeordnet sind, und die erste dielektrische Schicht über Hybridlaminierung auf der flexiblen dielektrischen Schicht (21) und den Prepreg-Schichten (22) ausgebildet ist, wobei die Prepreg-Schichten (22) ein Prepreg beinhalten, das die Oberseite der flexiblen dielektrischen Schicht (21) teilweise oder vollständig bedeckt, und die Prepreg-Schichten (22) ein Prepreg beinhalten, das die Unterseite der flexiblen dielektrischen Schicht (21) teilweise oder vollständig bedeckt, und die flexible dielektrische Schicht (21) unter Verwendung der Prepreg-Schichten (22) sowohl mit der ersten leitfähigen Schicht (11) als auch der zweiten leitfähigen Schicht (12) eng verbunden ist.

2. Leiterplatte nach Anspruch 1, wobei die Kernplatte auch die andere Außenfläche der zwei gegenüberliegenden Außenflächen des Substrats bedeckt und auf dieser angeordnet ist.

3. Leiterplatte nach einem der Ansprüche 1 oder 2, wobei das Prepreg der Prepreg-Schichten (22) ein FR4-Prepreg ist.

4. Leiterplatte nach einem der Ansprüche 1 bis 3, wobei ein Kontaktfeld auf der ersten leitfähigen Schicht (11) angeordnet ist, und die flexible dielektrische Schicht (21) an einer Position angeordnet ist, die dem Kontaktfeld entspricht und auf der ersten dielektrischen Schicht liegt.

5. Leiterplatte nach einem der Ansprüche 1 bis 4, wobei das Substrat N dritte leitfähige Schichten und M zweite dielektrische Schichten umfasst, die dritten leitfähigen Schichten und die zweiten dielektrischen Schichten abwechselnd gestapelt sind, M = N + 1 und sowohl N als auch M natürliche Zahlen sind; und
ein Young'scher Modul der ersten dielektrischen Schicht kleiner als ein Young'scher Modul der zweiten dielektrischen Schicht ist.

6. Leiterplatte nach einem der Ansprüche 1 bis 5, wobei das Substrat N dritte leitfähige Schichten und M zweite dielektrische Schichten umfasst, die dritten leitfähigen Schichten und die zweiten dielektrischen Schichten abwechselnd gestapelt sind, M = N + 1 und sowohl N als auch M natürliche Zahlen sind; und
ein Teil der M zweiten dielektrischen Schichten die flexible dielektrische Schicht (21) umfasst; oder
jede der M zweiten dielektrischen Schichten die flexible dielektrische Schicht (21) umfasst.

7. Leiterplatte nach einem der Ansprüche 1 bis 6, wobei ein Wärmeausdehnungskoeffizient der flexiblen dielektrischen Schicht (21) in einer Richtung der X-Achse und einer Richtung der Y-Achse kleiner oder gleich 30 ist.

8. Leiterplatte nach einem der Ansprüche 1 bis 7, wobei die flexible dielektrische Schicht (21) aus einem Polyimidmaterial hergestellt ist.

9. Elektronische Vorrichtung, umfassend eine Leistungsvorrichtung und die Leiterplatte nach einem der Ansprüche 1 bis 8, wobei die Leistungsvorrichtung elektrisch mit der Leiterplatte verbunden ist.

## Revendications

1. Carte de circuit imprimé, comprenant : une carte noyau et un substrat, dans laquelle la carte noyau recouvre et est disposée sur l'une des deux surfaces extérieures opposées du substrat ; et la carte noyau comprend :
une première couche conductrice (11), située sur une face de la carte noyau et éloignée du substrat ;
une deuxième couche conductrice (12), située sur une face de la carte noyau et proche du substrat ; et
une première couche diélectrique, située entre la première couche conductrice (11) et la deuxième couche conductrice (12) et comprenant une couche diélectrique flexible (21), dans laquelle le module de Young de la couche diélectrique flexible (21) est inférieur ou égal à 15 GPa,
la carte de circuit imprimé étant **caractérisée en ce que**
la première couche diélectrique comprend également des couches préimprégnées (22) qui recouvrent et sont disposées sur une surface supérieure et une surface inférieure de la couche diélectrique flexible (21), et la première couche diélectrique est formée par laminage hybride sur la couche diélectrique flexible (21) et les couches préimprégnées (22), dans laquelle les couches préimprégnées (22) comportent un préimprégné qui recouvre partiellement ou complètement la surface supérieure de la couche diélectrique flexible (21) et les couches préimprégnées (22) comportent un préimprégné qui recouvre partiellement ou complètement la surface inférieure de la couche diélectrique flexible (21), et la couche diélectrique flexible (21) est étroitement reliée à la fois à la première couche conductrice (11) et à la deuxième couche conductrice (12) à l'aide des couches préimprégnées (22).

2. Carte de circuit imprimé selon la revendication 1, dans laquelle la carte noyau recouvre également et est disposée sur l'autre surface extérieure des deux surfaces extérieures opposées du substrat.

3. Carte de circuit imprimé selon l'une quelconque des revendications 1 à 2, dans laquelle le préimprégné des couches préimprégnées (22) est un préimprégné FR4.

4. Carte de circuit imprimé selon l'une quelconque des revendications 1 à 3, dans laquelle une pastille est disposée sur la première couche conductrice (11), et la couche diélectrique flexible (21) est disposée à une position qui correspond à la pastille et se situe dans la première couche diélectrique.

5. Carte de circuit imprimé selon l'une quelconque des revendications 1 à 4, dans laquelle le substrat comprend N troisièmes couches conductrices et M secondes couches diélectriques, les troisièmes couches conductrices et les secondes couches diélectriques sont empilées alternativement, M = N + 1, et N et M sont tous deux des nombres naturels ; et
le module de Young de la première couche diélectrique est inférieur au module de Young de la seconde couche diélectrique.

6. Carte de circuit imprimé selon l'une quelconque des revendications 1 à 5, dans laquelle le substrat comprend N troisièmes couches conductrices et M secondes couches diélectriques, les troisièmes couches conductrices et les secondes couches diélectriques sont empilées alternativement, M = N + 1, et N et M sont tous deux des nombres naturels ; et une partie des M secondes couches diélectriques comprend la couche diélectrique flexible (21) ; ou
chacune des M secondes couches diélectriques comprend la couche diélectrique flexible (21).

7. Carte de circuit imprimé selon l'une quelconque des revendications 1 à 6, dans laquelle un coefficient de dilatation thermique de la couche diélectrique flexible (21) dans une direction d'axe X et une direction d'axe Y est inférieur ou égal à 30.

8. Carte de circuit imprimé selon l'une quelconque des revendications 1 à 7, dans laquelle la couche diélectrique flexible (21) est constituée d'un matériau polyimide.

9. Dispositif électronique, comprenant un dispositif d'alimentation et la carte de circuit imprimé selon l'une quelconque des revendications 1 à 8, dans lequel le dispositif d'alimentation est relié électriquement à la carte de circuit imprimé.
